# EUROPÄISCHE PATENTSCHRIFT

(11) **EP 0 782 768 B1**
(45) Veröffentlichungstag und Bekanntmachung des Hinweises auf die Patenterteilung: **19.12.2001**
(21) Anmeldenummer: 95929765.6
(22) Anmeldetag: 06.09.1995
(51) Int. Cl.: H01L 27/08

(54) **INTEGRIERTE SCHALTUNGSSTRUKTUR MIT EINEM AKTIVEN MIKROWELLENBAUELEMENT UND MINDESTENS EINEM PASSIVEN BAUELEMENT**
INTEGRATED CIRCUIT STRUCTURE WITH AN ACTIVE MICROWAVE ELEMENT AND AT LEAST ONE PASSIVE ELEMENT
STRUCTURE INTEGREE DE CIRCUIT COMPORTANT UN COMPOSANT A MICRO-ONDES ACTIF ET AU MOINS UN COMPOSANT PASSIF

(30) Priorität: 14.09.1994 DE 4432727
(43) Veröffentlichungstag der Anmeldung: 09.07.1997
(73) Patentinhaber: Infineon Technologies AG, 81669 München (DE)
(72) Erfinder: AEUGLE, Thomas, D-81735 München (DE)
(74) Vertreter: Zedlitz, Peter, Dipl.-Inf.
(86) Internationale Anmeldenummer: DE9501213
(87) Internationale Veröffentlichungsnummer: WO9608843

(56) Entgegenhaltungen:
- EP-A- 0 495 206
- WO-A-92/05580
- US-A- 4 851 794
- US-A- 4 969 032
- US-A- 5 063 177
- PATENT ABSTRACTS OF JAPAN vol. 017 no. 261 (E-1369) ,21.Mai 1993 & JP,A,05 003403 (SHARP CORP) 8.Januar 1993,
- PATENT ABSTRACTS OF JAPAN vol. 008 no. 039 (E-228) ,21.Februar 1984 & JP,A,58 197762 (NIPPON DENKI KK) 17.November 1983,
- Gallium Arsenide, ed. Howes & Morgan pub. J.Wiley 1985, pgs. 453-454
- IEEE Trans.Microwave Theory and Tech., vol.31,no.7(1983) pgs. 558-566

## Beschreibung

Integrierte Schaltungsstruktur mit einem aktiven Mikrowellenbauelement und mindestens einem passiven Bauelement, das als Spule ausgebildet ist.

Für Mikrowellenschaltungen, vielfach auch als Millimeterwellenschaltungen bezeichnet, werden neben aktiven Mikrowellenbauelementen passive Bauelemente benötigt. Als passive Bauelemente werden zum Beispiel Kondensatoren oder Spulen bezeichnet, die zum Aufbau von Filtern eingesetzt werden.

Zur Auswahl eines engen Hochfrequenzbandes aus dem von dem aktiven Mikrowellenbauelement emittierten Frequenzspektrum werden darüber hinaus Resonatoren benötigt.

Als aktive Mikrowellenbauelemente werden üblicherweise IM-PATT-Dioden, Gunn-Dioden oder schnelle Transistoren, insbesondere Heterobipolartransistoren und Hochfrequenz-MOS-Transistoren verwendet.

Beim Betrieb der Mikrowellenschaltung bei Hochfrequenzen, insbesondere über 50 GHz, kommt es bedingt durch die Geometrie der passiven Bauelemente zur parasitären Effekten. Diese führen dazu, daß sich Spulen und Kondensatoren nicht mehr wie Spulen bzw. Kondensatoren verhalten.

Für diesen Frequenzbereich werden Filter meist als Leitungslängenbauelement aufgebaut. Dabei wird die Leitung unterbrochen, so daß eine Lücke entsteht. Beträgt die Länge der Lücke in Fortpflanzungsrichtung einer Welle λ/2, so wird eine Welle mit der Wellenlänge λ durchgelassen, während andere Wellenlängen an der Lücke reflektiert werden. Der Platzbedarf derartiger Leitungslängenbauelemente ist mit der Wellenlänge und damit der Frequenz verknüpft.

Als Resonatoren werden in diesem Frequenzbereich Schlitzresonatoren oder planare Scheibenresonatoren verwendet. Als Schlitzresonatoren werden wiederum Spalten in Leitungen bezeichnet, die eine Ausdehnung entsprechend einem ganzzahligen Vielfachen von λ/2 haben. Aus Impedanzgründen sind dabei Spalte mit einer Ausdehnung von ganzzahligen Vielfachen von λ vorzuziehen. Die Abmessungen eines Schlitzresonators sind daher wiederum an die Wellenlänge gekoppelt.

Als planare Scheibenresonatoren werden scheibenförmige Vergrößerungen des Leitungsquerschnitts bezeichnet. Für bestimmte Querschnitte derartiger Scheiben tritt Resonanz auf.

Mikrowellenschaltungen werden meist in konventioneller Streifenleitungstechnologie aufgebaut (siehe zum Beispiel H. H. Meinel, Millimeter-Wave Technology advances since 1985 and Future trends, IEEE Transaction on microwave theory and techniques, Vol. 39, Nr. 5, 1991, Seiten 759 bis 767). In der Streifenleitungstechnologie breitet sich das elektromagnetische Feld zwischen einer Streifenleitung und einer geerdeten Metallplatte aus. Die geerdete Metallplatte und die Streifenleitung sind dabei auf gegenüberliegenden Oberflächen eines isolierenden Substrates, zum Beispiel einer Leiterplatte, angeordnet. Die Packungsdichte der Streifenleitungen wird dabei durch seitliche Feldkomponenten begrenzt. Ferner ist die Impedanz der Streifenleitung stark abhängig von der Substratdicke, so daß sich Substratdickenschwankungen störend bemerkbar machen.

Das Problem der Substratdickenschwankungen wird durch Einsatz koplanarer Leitungen vermieden, wie zum Beispiel aus D. F. Williams et al, Design and performance of coplanar wave guide bandpass filters, IEEE Transaction on microwave theory and techniques, Vol. MTT-31, Nr. 7, 1983, Seiten 558 bis 565 bekannt ist. Auf einem isolierenden Substrat, meist aus hochohmigem GaAs, sind Leitungen angeordnet, die zwischen geerdeten Leitungen verlaufen. Das elektromagnetische Feld breitet sich hier zwischen der Leitung und den geerdeten Leitungen aus. Das Substrat dient im wesentlichen zur mechanischen Stabilisierung.

Auf GaAs-Substraten werden die Leitungen unter Verwendung von Galvanotechnologien hergestellt, die relativ grob strukturierbar sind. Auf diese Weise können Strukturen mit einer Strukturgröße größer 5 µm hergestellt werden.

Für viele Hochfrequenzanwendungen, zum Beispiel Doppler-Radar, werden hybride Aufbauten eingesetzt.

In der US 5,063,177 ist eine Anordnung mit einer monolithisch integrierten Mikrowellenschaltung (MMIC) beschrieben, bei der der MMIC als Chip in eine Aussparung eines Siliziumsubstrates eingesetzt und mittels Bonddrähten mit einer Übertragungsstrecke verbunden ist.

In dem Band "Gallium Arsenide" (M. J. Howes und D. V. Morgan, Hg.), Wiley 1985, sind in Kapitel 12 MMICs in GaAs beschrieben.

In der WO 92/05580 ist eine integrierte Schaltungsanordnung mit einem aktiven Mikrowellenbauelement in einem hochohmigen monokristallinen Siliziumsubstrat beschrieben. Die geerdete Elektrode ist dabei an der Unterseite des Substrates aufgebracht.

In der US 4,969,032 ist ein MMIC beschrieben, bei dem die Bauelemente vertikal übereinander angeordnet und mit einer dreilagigen Metallisierung versehen sind.

In der EP 0 495 206 A2 ist eine Anordnung mit einem MMIC beschrieben, der ein aktives Oszillatorelement und einen resonanten Kondensator aufweist und mittels Flip-Chip-Montage auf einem dielektrischen Substrat befestigt ist. Der Kondensator ist mit einem als resonante Induktivität vorgesehenen Leitungslängenbauelement verbunden.

In der US 4,851,794 ist eine Anordnung beschrieben, die als Koppelbauelement für den Übergang zwischen Mikrowellenstreifenleitern und koplanaren Wellenleitern vorgesehen ist. Die Wellenleiter können auf einem Halbleiterkörper mit integrierten Schaltungen angeordnet sein.

Der Erfindung liegt das Problem zugrunde, eine integrierte Schaltungsanordnung mit einem aktiven Mikrowellenbauelement und einem passiven Bauelement, das als Spule ausgebildet ist, anzugeben, die für Frequenzen oberhalb 50 GHz einsetzbar ist und bei der der Platzbedarf der Bauelemente gegenüber dem Stand der Technik weiter reduziert ist.

Dieses Problem wird erfindungsgemäß gelöst durch eine integrierte Schaltungsstruktur gemäß Anspruch 1. Weitere Ausgestaltungen der Erfindung gehen aus den übrigen Ansprüchen hervor.

Die integrierte Schaltungsstruktur ist auf einem Substrat aus hochohmigem monokristallinem Silizium aufgebaut. Das Substrat weist insbesondere einen spezifischen Widerstand von ≥ 1000 Ωcm auf. Derartige Siliziumsubstrate sind aufgrund verbesserter Kristallwachstumsverfahren seit kurzem erhältlich.

Das Substrat umfaßt ein aktives Mikrowellenbauelement, insbesondere eine IMPATT-Diode, eine Gunn-Diode, einen Heterobipolartransistor oder einen Hochgeschwindigkeits-MOS-Transistor. Das Substrat ist ferner mit mindestens zwei Metallisierungsebenen versehen, die durch eine Isolationsschicht gegeneinander isoliert sind. Das passive Bauelement wird durch Metallstrukturen in den beiden Metallisierungsebenen realisiert. Eine der Metallstrukturen ist dabei zwischen geerdeten Leitungen angeordnet, die in derselben Metallisierungsebene wie die betreffende Metallstruktur realisiert sind. Die erfindungsgemäße Schaltungsstruktur ist somit koplanar aufgebaut.

Gemäß der Erfindung ist das passive Bauelement als Spule ausgebildet. Dazu ist in einer ersten Metallisierungsebene eine erste Metallstruktur als spiralförmig angeordnete Leiterbahn ausgebildet. Als spiralförmig wird in diesem Zusammenhang sowohl eine Anordnung bezeichnet, die in jeder einzelnen Windung einen runden Querschnitt aufweist, als auch eine Anordnung, die in jeder einzelnen Windung einen eckigen, insbesondere viereckigen Querschnitt aufweist. Die spiralförmig angeordnete Leiterbahn ist von geerdeten Leitungen, die ebenfalls in der ersten Metallisierungsebene realisiert sind, umgeben. In der zweiten Metallisierungsebene ist eine zweite Metallstruktur vorgesehen, die sich mindestens von der Mitte der ersten Metallstruktur bis zum Rand der ersten Metallstruktur erstreckt. Die zweite Metallstruktur ist zum Beispiel als Geradenstück ausgebildet. Über ein mit einem Kontakt gefülltes Kontaktloch ist die zweite Metallstruktur mit der ersten Metallstruktur elektrisch verbunden. Das Kontaktloch ist vorzugsweise in der Mitte der spiralförmig angeordneten Leiterbahn angeordnet.

Die Spule ist somit planar ausgebildet, wobei der eine Anschluß der Spule über die zweite Metallstruktur aus der Spule herausgeführt wird. In dieser Ausführungsform wird die Breite der spiralförmig angeordneten Leiterbahn so gewählt, daß sie klein gegen die auftretende Wellenlänge des elektromagnetischen Feldes ist.

Gemäß einer weiteren Ausführungsform der Erfindung umfaßt die integrierte Schaltungsstruktur zwei passive Bauelemente, von denen das eine als Kondensator und das andere als Spule ausgebildet sind. In der einen Metallisierungsebene ist dabei eine erste Elektrode und in der anderen Metallisierungsebene eine zweite Elektrode des Kondensators angeordnet. Die erste und die zweite Elektrode des Kondensators überlappen sich. Die dazwischen angeordnete Isolationsschicht bildet das Dielektrikum. Die Kontaktierung der Kondensatorelektroden mit jeweils in der anderen Metallisierungsebene realisierten Leitungsstrukturen erfolgt mit Kontakten, die aus gefüllten Kontaktlöchern in der Isolationsschicht bestehen. Ein erfindungsgemäßer Resonator, der für eine Frequenz von zum Beispiel 77 GHz ausgelegt ist, weist eine Länge von ca. 150 µm auf und hat einen Flächenbedarf unter 100 µm². Im Vergleich dazu hätte ein in koplanarer Technologie hergestellter Schlitzresonator für 77 GHz eine Länge von 1400 µm.

Da die passiven Bauelemente in der erfindungsgemäßen Schaltungsstruktur aus Metallstrukturen aufgebaut werden, die in zwei Metallisierungsebenen angeordnet sind, ist die Strukturbreite in den Metallstrukturen durch die erzielbare Auflösung bei der Strukturierung von Metallisierungsebenen in der Siliziumprozeßtechnik gegeben. Strukturbreiten um 1 µm sind in der Technologie ohne weiteres erzielbar.

Ein weiterer Vorteil der erfindungsgemäßen integrierten Schaltungsstruktur besteht darin, daß in dem Substrat zusätzlich weitere Bauelemente insbesondere die Ansteuer- und Auswerteelektronik sowie Elektronik zur digitalen Verarbeitung integriert hergestellt werden können.

Im folgenden wird die Erfindung anhand von Ausführungsbeispielen und der Figuren näher erläutert.
- Figur 1und Figur 2 zeigt: Aufsicht und Schnitt einer Schaltungsanordnung mit einer Spule.
- Figur 3 und Figur 4 zeigt: Aufsicht und Schnitt einer Schaltungsanordnung mit einem Kondensator.
- Figur 5 und Figur 6 zeigt: Aufsicht und Schnitt einer Schaltungsanordnung mit einem Kondensator.
- Figur 7 und Figur 8 zeigt: Aufsicht und Querschnitt einer Schaltungsanordnung mit einem Resonator.

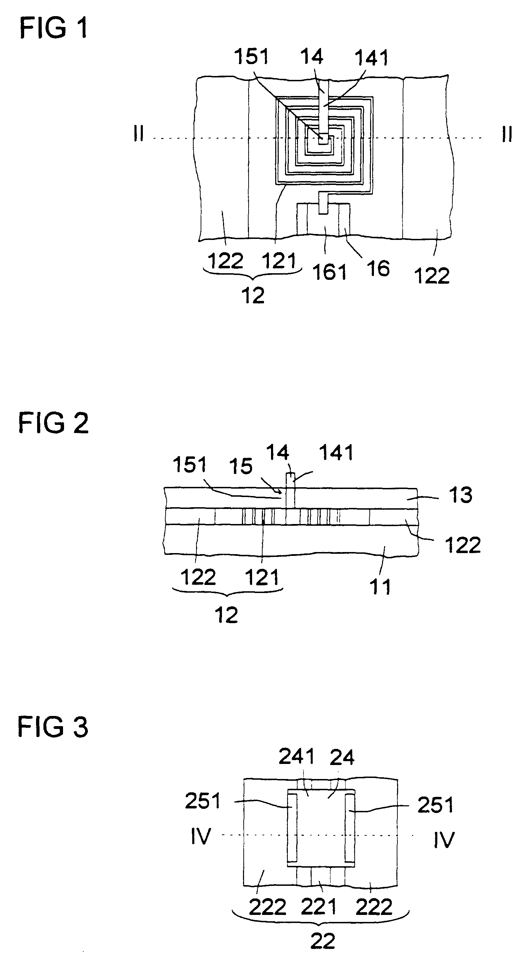

Auf einem Substrat 11 aus hochohmigem monokristallinem Silizium mit einem spezifischen Widerstand von zum Beispiel 1000 Ωcm ist eine erste Metallisierungsebene 12, eine Isolationsschicht 13 und eine zweite Metallisierungsebene 14 angeordnet (siehe Figur 1 und Figur 2; Figur 2 zeigt den in Figur 1 mit II-II bezeichneten Schnitt). Die Isolationsschicht 13 ist in Figur 1 der Übersichtlichkeit halber nicht dargestellt.

Die erste Metallisierungsebene 12 umfaßt eine erste Metallstruktur 121 und geerdete Leitungen 122. Die erste Metallisierungsebene 12 besteht aus einem Metall, zum Beispiel Aluminium, Gold, Wolfram oder dotiertes Polysilizium, das eine Schichtdicke von 1 µm aufweist.

Die erste Metallstruktur 121 ist als spiralförmig angeordnete Leiterbahn ausgebildet, wobei die Leiterbahnbreite etwa 10 µm beträgt. Zwischen benachbarten Windungen ist ein Isolator, zum Beispiel Luft oder ein Teil der Isolationsschicht 13 angeordnet.

Die erste Metallstruktur 121 ist zwischen den geerdeten Leitungen 122 angeordnet. Die geerdeten Leitungen 122 weisen eine Breite von zum Beispiel ≥ 50 µm auf.

Die Isolationsschicht 13 wird aus SiO₂ und/oder Si₃N₄ in einer Schichtdicke von etwa 2 µm oberhalb der ersten Metallisierungsebene 12 abgeschieden. Auf die Isolationsschicht 13 wird die zweite Metallisierungsebene 14 aufgebracht, die aus einem Metall, zum Beispiel Aluminium, Gold, Wolfram oder dotiertes Polysilizium in einer Schichtdicke von etwa 1 µm gebildet wird. In der zweiten Metallisierungsebene 14 ist eine zweite Metallstruktur 141 ausgebildet, die oberhalb der ersten Metallstruktur 121 verläuft. Die zweite Metallstruktur 141 ist zum Beispiel als Geradenstück ausgebildet, das von der Mitte der ersten Metallstruktur 121 bis zum Rand der ersten Metallstruktur 121 reicht. Über ein Kontaktloch 15, das mit einem Kontakt 151 aus zum Beispiel Aluminium, Gold, Wolfram oder dotiertes Polysilizium gefüllt ist, ist die zweite Metallstruktur 141 mit der ersten Metallstruktur 121 elektrisch verbunden. Das Kontaktloch 15 ist in etwa in der Mitte der ersten Metallstruktur 121 angeordnet.

Im Substrat 11 ist ein aktives Mikrowellenbauelement 16, zum Beispiel eine IMPATT-Diode oder ein schneller Transistor, angeordnet das mit einem Anschluß 161, der in der ersten Metallisierungsebene 12 realisiert ist, mit der ersten Metallstruktur 121 elektrisch verbunden ist. Außerhalb der Zeichnung ist ein zweiter Anschluß des aktiven Mikrowellenbauelementes 16 mit der geerdeten Leitung 122 verbunden.

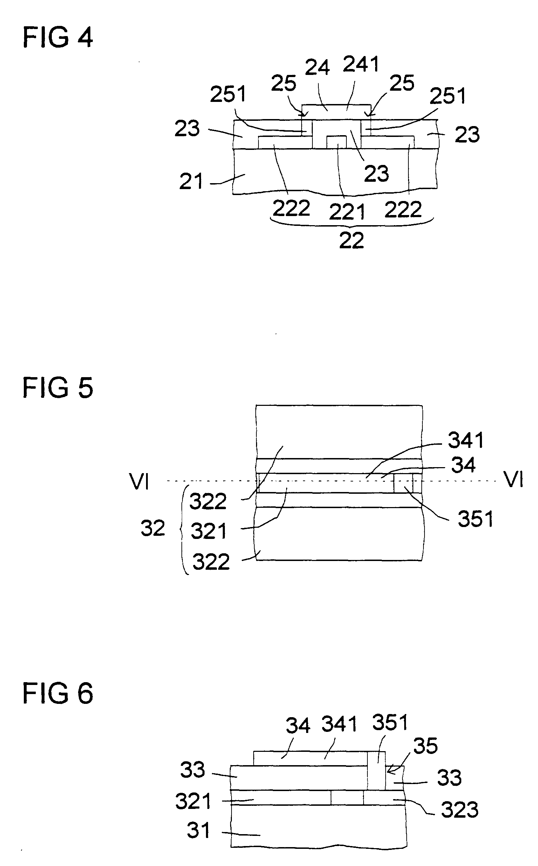

In einem Substrat 21 aus hochohmigem monokristallinem Silizium mit einem spezifischen Widerstand von zum Beispiel 1000 Ωcm ist eine erste Metallisierungsebene 22, eine Isolationsschicht 23 und eine zweite Metallisierungsebene 24 angeordnet (siehe Figur 3 und Figur 4; Figur 4 zeigt den in Figur 3 mit IV-IV bezeichneten Schnitt).

Die erste Metallisierungsebene 22 umfaßt eine erste Elektrode 221 und geerdete Leitungen 222, zwischen denen die erste Elektrode 221 angeordnet ist. Die erste Metallisierungsebene 22 ist in einer Schichtdicke von 1 µm aus einem Metall, zum Beispiel Aluminium, Gold, Wolfram oder dotiertes Polysilizium, gebildet. Die erste Elektrode 221 weist eine Breite von zum Beispiel 25 µm auf. Die geerdeten Leitungen 222 weisen eine Breite von zum Beispiel ≥ 50 µm auf.

Die Isolationsschicht 23 wird aus SiO₂ und/oder Si₃N₄ in einer Schichtdicke über der ersten Metallisierungsebene 22 von zum Beispiel 2 µm hergestellt.

Die zweite Metallisierungsebene 24 umfaßt eine zweite Elektrode 241, die die erste Elektrode 221 seitlich überlappt. Die zweite Elektrode 241 reicht bis über die geerdeten Leitungen 222.

Die zweite Metallisierungsebene 24 weist eine Schichtdicke von zum Beispiel 1 µm auf und besteht aus einem Metall, zum Beispiel Aluminium, Gold, Wolfram oder dotiertem Polysilizium. Die Isolationsschicht 23, die in der Aufsicht in Figur 3 der Übersichtlichkeit halber nicht dargestellt ist, weist eine Dicke von 2 µm auf und besteht aus SiO₂ und/oder Si₃N₄.

In dem Bereich, in dem die zweite Elektrode 241 die geerdeten Leitungen 222 überlappt, sind beidseits der ersten Elektrode 221 jeweils Kontaktlöcher 25 angeordnet, die mit Kontakten 251 aus zum Beispiel Aluminium, Gold, Wolfram oder dotiertem Polysilizium aufgefüllt sind. Über die Kontakte 251 ist die zweite Elektrode 241 mit den geerdeten Leitungen 222 elektrisch verbunden.

Die erste Elektrode 221, die zweite Elektrode 241 und die dazwischen angeordnete Isolationsschicht 23, die als Kondensatordielektrikum wirkt, bilden einen Kondensator, dessen zweite Elektrode 241 geerdet ist.

Außerhalb des in Figur 3 und Figur 4 gezeigten Ausschnittes ist in dem Substrat 21 ein aktives Mikrowellenbauelement integriert.

In einem Substrat 31 aus hochohmigem monokristallinem Silizium mit einem spezifischen Widerstand von zum Beispiel 1000 Ω cm sind eine erste Metallisierungsebene 32, eine Isolationsschicht 33 und eine zweite Metallisierungsebene 34 angeordnet (siehe Figur 5 und Figur 6; Figur 6 zeigt den in Figur 5 mit VI-VI bezeichneten Schnitt).

Die erste Metallisierungsebene 32 besteht aus einem Metall, zum Beispiel Aluminium, Gold, Wolfram oder dotiertem Polysilizium, und weist eine Dicke von zum Beispiel 1 µm auf. Die erste Metallisierungsebene 32 umfaßt eine erste Elektrode 321 und geerdete Leitungen 322, zwischen denen die erste Elektrode 321 angeordnet ist. Die geerdeten Leitungen 322 weisen eine Breite von zum Beispiel ≥ 50 µm auf.

Die Isolationsschicht 33 besteht zum Beispiel aus SiO₂ und/oder Si₃N₄ und weist eine Dicke von zum Beispiel 2 µm auf. Sie ist in der Aufsicht in Figur 5 der Übersichtlichkeit halber nicht dargestellt.

Die zweite Metallisierungsebene 34 besteht aus einem Metall, zum Beispiel Aluminium, Gold, Wolfram oder dotiertem Polysilizium, und weist eine Dicke von zum Beispiel 1 µm auf. Die zweite Metallisierungsebene 34 umfaßt eine zweite Elektrode 341, die oberhalb der ersten Elektrode 321 angeordnet ist und die die erste Elektrode 321 teilweise überlappt.

In der ersten Metallisierungsebene 32 ist ferner ein Leitungsstück 323 realisiert, zwischen dem und der ersten Elektrode 321 ein Abstand von etwa 15 µm besteht. Die zweite Elektrode 341 ist oberhalb dieses Abstands angeordnet und überlappt das Leitungsstück 323 teilweise. In dem Bereich, in dem die zweite Elektrode 321 das Leitungsstück 323 überlappt, ist ein Kontaktloch 35 angeordnet, das mit einem Kontakt 351 aus zum Beispiel Aluminium oder Wolfram gefüllt ist. Über den Kontakt 351 ist die zweite Elektrode 341 mit dem Leitungsstück 323 elektrisch verbunden.

Die erste Elektrode 321, die zweite Elektrode 341 und die dazwischen angeordnete Isolationsschicht 33, die ein Kondensatordielektrikum bildet, bilden einen Kondensator, der über das Leitungsstück 323 und die erste Elektrode 321 in der ersten Metallisierungsebene 32 verschaltbar ist.

Außerhalb des in Figur 5 und Figur 6 gezeigten Ausschnittes ist in dem Substrat 31 ein aktives Mikrowellenbauelement integriert.

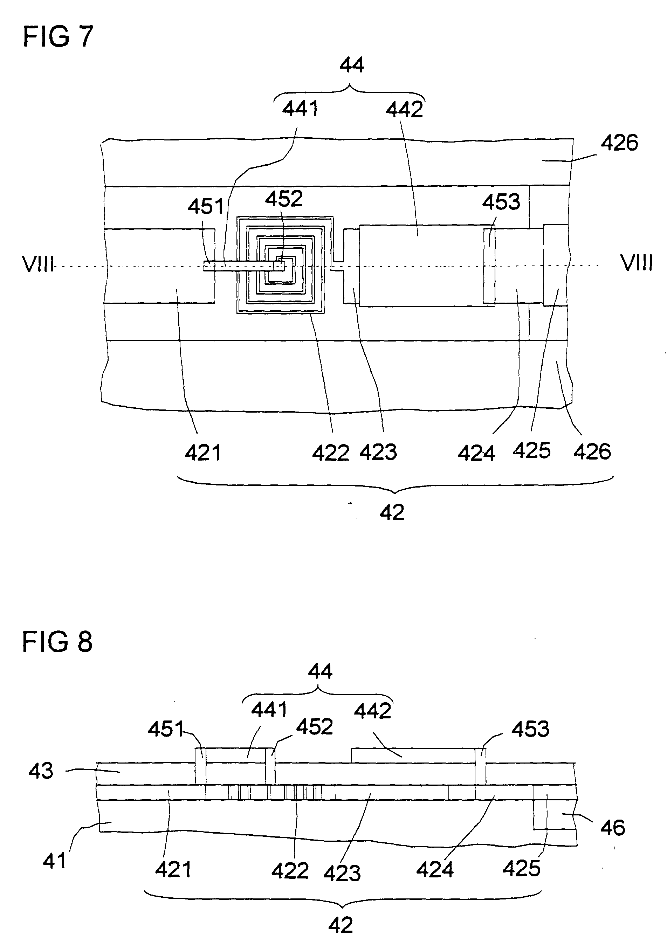

Auf einem Substrat 41 aus hochohmigem monokristallinem Silizium mit einem spezifischen Widerstand von zum Beispiel ≥ 1000 Ωcm sind eine erste Metallisierungsebene 42, eine Isolationsschicht 43 und eine zweite Metallisierungsebene 44 angeordnet (siehe Figur 7 und Figur 8; Figur 8 zeigt den in Figur 7 mit VIII-VIII bezeichneten Schnitt).

Die erste Metallisierungsebene umfaßt ein erstes Leitungsstück 421, eine spiralförmig angeordnete Leiterbahn 422, eine erste Kondensatorelektrode 423, ein zweites Leitungsstück 424, einen ersten Anschluß 425 für ein im Substrat 41 integriertes Mikrowellenbauelement 46 sowie geerdete Leitungen 426, zwischen denen das erste Leitungsstück 421, die spiralförmig angeordnete Leiterbahn 422, die erste Kondensatorelektrode 423, das zweite Leiterstück 424 und der erste Anschluß 425 angeordnet sind. Die spiralförmig angeordnete Leiterbahn 422 weist Strukturgrößen von etwa 10 µm auf. Die einzelnen Windungen der spiralförmig angeordneten Leiterbahn weisen einen viereckigen Querschnitt auf. Die erste Metallisierungsebene 42 besteht aus einem Metall, zum Beispiel Aluminium, Wolfram oder Gold und weist eine Dicke von zum Beispiel 1 µm auf. Die Leitungen 422 weisen eine Breite von zum Beispiel 2 µm auf.

Die Isolationsschicht 43 besteht zum Beispiel aus SiO₂ und/oder Si₃N₄ und weist oberhalb der ersten Metallisierungsebene 42 eine Dicke von zum Beispiel 2 µm auf. Sie ist in Figur 7 der Übersichtlichkeit halber nicht dargestellt.

Die zweite Metallisierungsebene 44 umfaßt ein Anschlußstück 441 und eine zweite Kondensatorelektrode 442. Das Anschlußstück 441 ist oberhalb der spiralförmig angeordneten Leiterbahn 422 angeordnet. Es überlappt mindestens den Bereich von der Mitte der spiralförmig angeordneten Leiterbahn 422 bis zum ersten Leitungsstück 421. Über einen ersten Kontakt 451, der in einem Kontaktloch in der Isolationsschicht 44 angeordnet ist, ist das erste Leitungsstück 421 mit dem Anschlußstück 441 elektrisch verbunden. Über einen zweiten Kontakt 452, der in einem in der Isolationsschicht angeordneten Kontaktloch angeordnet ist, ist das Anschlußstück 441 mit der spiralförmig angeordneten Leiterbahn 422 in der ersten Metallisierungsebene 42 elektrisch verbunden. Über das Anschlußstück 441 ist die spiralförmig angeordnete Leiterbahn 422 mit dem ersten Leistungsstück 421 elektrisch verbunden.

Die zweite Kondensatorelektrode 442 ist oberhalb der ersten Kondensatorelektrode 423 angeordnet. Die zweite Kondensatorelektrode 442 überragt die erste Kondensatorelektrode 423 seitlich und reicht bis über das zweite Leitungsstück 424. Die zweite Kondensatorelektrode 442 überragt dabei einen Spalt, der in der ersten Metallisierungsebene 42 zwischen der ersten Kondensatorelektrode 423 und dem zweiten Leitungsstück 424 besteht.

In dem Bereich, in dem die zweite Kondensatorelektrode 442 das zweite Leitungsstück 424 überragt, ist ein dritter Kontakt 453 in einem Kontaktloch angeordnet, über den die zweite Kondensatorelektrode 442 mit dem zweiten Leitungsstück 424 elektrisch verbunden ist.

Die spiralförmig angeordnete Leiterbahn 422 ist mit der ersten Kondensatorelektrode 423 elektrisch verbunden, so daß die aus spiralförmig angeordneter Leiterbahn 422 und Anschlußstück 441 gebildete Spule zwischen das erste Leitungsstück 421 und die erste Kondensatorelektrode 423 geschaltet ist. Die erste Kondensatorelektrode 423 und die zweite Kondensatorelektrode 442 sowie die dazwischen angeordnete Isolationsschicht 43 bilden einen Kondensator, der mit der Spule und dem zweiten Leitungsstück 424 in Reihe geschaltet ist. Das zweite Leitungsstück 424 ist mit dem ersten Anschluß 425 des aktiven Mikrowellenbauelementes 46, zum Beispiel einer IMPATT-Diode oder einem Hochgeschwindigkeitstransistor, elektrisch verbunden. Ein zweiter Anschluß des Mikrowellenbauelements 46, der in Figur 7 und Figur 8 nicht dargestellt ist, ist mit den geerdeten Leitungen 426 verbunden.

Die anhand von Figur 7 und 8 beschriebene Schaltungsanordnung mit Spule, Kondensator und Mikrowellenbauelement bildet einen koplanaren Serienresonanzkreis, in dem Spule und Kondensator als Resonator wirken. Der Flächenbedarf des Resonators bei einem Betrieb bei 77 GHz beträgt weniger als 100 µm². Die Länge des Resonators beträgt etwa 150 µm und ist damit erheblich geringer als die für einen Schlitzresonator erforderliche Länge von 1400 µm bei 77 GHz.

## Patentansprüche

1. Integrierte Schaltungsstruktur mit einem aktiven Mikrowellenbauelement und mindestens einem passiven Bauelement als Spule,
- bei der ein Substrat (11) aus hochohmigem, monokristallinem Silizium vorgesehen ist, in dem das aktive Mikrowellenbauelement integriert ist,
- bei der das Substrat (11) mindestens eine erste Metallisierungsebene (12), eine zweite Metallisierungsebene (14) und eine dazwischen angeordnete Isolationsschicht (13) umfaßt,
- bei der das passive Bauelement mindestens eine erste Metallstruktur (121), die in der ersten Metallisierungsebene (12) realisiert ist, und eine zweite Metallstruktur (141), die in der zweiten Metallisierungsebene (14) realisiert ist, umfaßt, wobei eine der Metallstrukturen (121) als Koplanare Schaltungsstruktur zwischen als geerdete Leitungen vorgesehenen Leitungen (122) angeordnet ist, die in derselben Metallisierungsebene (12) realisiert sind, und diese eine Metallstruktur (121) als spiralförmig angeordnete Leiterbahn ausgebildet ist.

2. Schaltungsstruktur nach Anspruch 1,
- wobei die erste Metallstruktur (121) als spiralförmig angeordnete Leiterbahn ausgebildet, die von geerdeten Leitungen (122) umgeben ist,
- wobei sich die zweite Metallstruktur (141) mindestens von der Mitte der ersten Metallstruktur (121) bis zum Rand der ersten Metallstruktur (121) erstreckt und
- wobei die zweite Metallstruktur (141) über ein mit einem Kontakt (151) gefülltes Kontaktloch (15) in der Isolationsschicht (13) mit der ersten Metallstruktur (121) elektrisch verbunden ist.

3. Schaltungsstruktur nach Anspruch 1, bei der ein weiteres passives Bauelement als Kondensator ausgebildet ist, wobei die erste Metallstruktur (221) und die zweite Metallstruktur (241) eine erste Elektrode und eine zweite Elektrode des Kondensators bilden und sich überlappen.

4. Schaltungsstruktur nach Anspruch 3,
- bei der die erste Elektrode (221) als Teil einer Signalleitung ausgebildet ist, die zwischen geerdeten Leitungen (222) verläuft,
- bei der die zweite Elektrode (241) über zwei mit Kontakten (251) versehene Kontaktlöcher (25) in der Isolationsstruktur (23) an gegenüberliegenden Seiten der Signalleitung mit den geerdeten Leitungen (222) elektrisch verbunden ist.

5. Schaltungsstruktur nach Anspruch 3,
- bei der die erste Elektrode (321) als Teil einer Signalleitung ausgebildet ist, die zwischen geerdeten Leitungen (322) angeordnet ist,
- bei der die Signalleitung durch einen Spalt unterbrochen ist,
- bei der die zweite Elektrode (341) den Spalt überlappt und über ein mit einem Kontakt (351) versehenes Kontaktloch (35) in der Isolationsschicht (33) mit der Signalleitung (323) auf der der ersten Elektrode (321) abgewandten Seite des Spaltes elektrisch verbunden ist.

6. Schaltungsstruktur nach Anspruch 1,
- bei der zwei passive Bauelemente vorgesehen sind, von denen das eine als Spule und das andere als Kondensator ausgebildet ist,
- bei der der Kondensator zwei Elektroden (423, 442) umfaßt, von denen die eine in der einen Metallisierungsebene (42) und die andere in der anderen Metallisierungsebene (44) realisiert ist,
- bei der die Spule in der einen Metallisierungsebene eine spiralförmig angeordnete Leiterbahn (422) umfaßt, die über ein mit einem Kontakt (452) versehenes Kontaktloch in der Isolationsschicht (43) mit einem in der anderen Metallisierungsebene (44) realisiertem Anschlußstück (441) verbunden ist, das quer zur spiralförmig angeordneten Leiterbahn (422) verläuft.

7. Schaltungsstruktur nach Anspruch 6, bei der die Spule, der Kondensator und das aktive Mikrowellenbauelement entlang einer Signalleitung in Reihe verschaltet sind, wobei die Spule und der Kondensator einen Resonator bilden.

8. Schaltungsstruktur nach Anspruch 7,
- bei der in der ersten Metallisierungsebene (42) ein erstes Leitungsstück (421) und ein zweites Leitungsstück (424) angeordnet sind, die zwischen geerdeten Leitungen in der ersten Metallisierungsebene (42) verlaufen,
- bei der die spiralförmig angeordnete Leiterbahn (422) der Spule in der ersten Metallisierungsebene (42) zwischen dem ersten Leitungsstück (421) und dem zweiten Leitungsstück (424) angeordnet ist,
- bei der das Anschlußstück (441) der Spule in der zweiten Metallisierungsebene (42) angeordnet ist und über einen ersten Kontakt (451), der in einem Kontaktloch angeordnet ist, mit dem ersten Leitungsstück (421) und über einen zweiten Kontakt (452), der in einem Kontaktloch angeordnet ist, im Bereich der Mitte der Spule mit der spiralförmig angeordneten Leiterbahn (422) der Spule elektrisch verbunden ist,
- bei der in der ersten Metallisierungsebene (42) zwischen der spiralförmig angeordneten Leiterbahn (422) und dem zweiten Leitungsstück (424) eine erste Kondensatorelektrode (423) des Kondensators angeordnet ist, die mit der spiralförmig angeordneten Leiterbahn (422) der Spule elektrisch verbunden ist,
- bei der in der zweiten Metallisierungsebene (44) eine zweite Kondensatorelektrode (442) des Kondensators angeordnet ist, die die erste Kondensatorelektrode (423) überlappt und die über einen dritten Kontakt (453) mit dem zweiten Leitungsstück (424) verbunden ist,
- bei der ein erster Anschluß (425) des aktiven Mikrowellenbauelementes mit einem der Leitungsstücke (421, 424) und ein zweiter Anschluß des aktiven Mikrowellenbauelementes (46) mit den geerdeten Leitungen (426) elektrisch verbunden ist.

9. Schaltungsstruktur nach einem der Ansprüche 1 bis 8, bei der das aktive Bauelement als IMPATT-Diode, Gunn-Diode, Heterobipolartransistor oder Hochfrequenz-MOS-Transistor ausgebildet ist.

10. Schaltungsstruktur nach einem der Ansprüche 1 bis 9, bei der das hochohmige Substrat einen spezifischen Widerstand von mindestens 1000 Ωcm aufweist.

## Claims

1. Integrated circuit structure having an active microwave component and at least one passive component as coil,
- in which a substrate (11) made of high-resistance monocrystalline silicon is provided, in which the active microwave component is integrated,
- in which the substrate (11) comprises at least a first metallization plane (12), a second metallization plane (14), and an insulation layer (13) arranged in between,
- in which the passive component comprises at least a first metal structure (121), which is realized in the first metallization plane (12), and a second metal structure (141), which is realized in the second metallization plane (14), one of the metal structures (121) being arranged as a coplanar circuit structure between lines (122) which are provided as earthed lines and are realized in the same metallization plane (12), and said metal structure (121) being designed as a conductor track which is arranged in the form of a spiral.

2. Circuit structure according to Claim 1,
- the first metal structure (121) being designed as a conductor track which is arranged in the form of a spiral and is surrounded by earthed lines (122),
- the second metal structure (141) extending at least from the centre of the first metal structure (121) up to the edge of the first metal structure (121), and
- the second metal structure (141) being electrically connected to the first metal structure (121) via a contact hole (15) in the insulation layer (13), which hole is filled with a contact (151).

3. Circuit structure according to Claim 1, in which a further passive component is designed as a capacitor, the first metal structure (221) and the second metal structure (241) forming a first electrode and a second electrode of the capacitor and overlapping.

4. Circuit structure according to Claim 3,
- in which the first electrode (221) is designed as part of a signal line which runs between earthed lines (222),
- in which the second electrode (241) is electrically connected to the earthed lines (222) via two contact holes (25), provided with contacts (251), in the insulation structure (23) on opposite sides of the signal line.

5. Circuit structure according to Claim 3,
- in which the first electrode (321) is designed as part of a signal line which is arranged between earthed lines (322),
- in which the signal line is interrupted by a gap,
- in which the second electrode (341) overlaps the gap and is electrically connected to the signal line (323), on that side of the gap which faces away from the first electrode (321), via a contact hole (35), provided with a contact (351), in the insulation layer (33).

6. Circuit structure according to Claim 1,
- in which two passive components are provided, of which one is designed as a coil and the other is designed as a capacitor,
- in which the capacitor comprises two electrodes (423, 442), of which one is realized in one metallization plane (42) and the other is realized in the other metallization plane (44),
- in which a second capacitor electrode (442) of the capacitor is arranged in the second metallization plane (44), which electrode overlaps the first capacitor electrode (423), and is connected to the second line section (424) via a third contact (453),
- in which a first terminal (425) of the active microwave component is electrically connected to one of the line sections (421, 424) and a second terminal of the active microwave component (46) is electrically connected to the earthed lines (426).

7. Circuit structure according to Claim 6,
in which the coil, the capacitor and the active microwave component are connected in series along a signal line, the coil and the capacitor forming a resonator.

8. Circuit structure according to claim 7,
- in which a first line section (421) and a second line section (424) are arranged in the first metallization plane (42), which line sections run between earthed lines in the first metallization plane (42),
- in which the conductor track (422), arranged in the form of a spiral, of the coil is arranged in the first metallization plane (42) between the first line section (421) and the second line section (424),
- in which the connection section (441) of the coil is arranged in the second metallization plane (42) and is electrically connected to the first line section (421) via a first contact (451), which is arranged in a contact hole, and is electrically connected to the conductor track (422), arranged in the form of a spiral, of the coil via a second contact (452), which is arranged in a contact hole, in the region of the centre of the coil,
- in which a first capacitor electrode (423) of the capacitor is arranged in the first metallization plane (42) between the conductor track (422) arranged in the form of a spiral and the second line section (424), which electrode is electrically connected to the conductor track (422), arranged in the form of a spiral, of the coil,
- in which a second capacitor electrode (442) of the capacitor is arranged in the second metallization plane (44), which electrode overlaps the first capacitor electrode (423), and is connected to the second line section (424) via a third contact (453),
- in which a first terminal (425) of the active microwave component is electrically connected to one of the line sections (421, 424) and a second terminal of the active microwave component (46) is electrically connected to the earthed lines (426).

9. Circuit structure according to one of Claims 1 to 8,
in which the active component is designed as an IMPATT diode, Gunn diode, heterojunction bipolar transistor or high-frequency MOS transistor.

10. Circuit structure according to one of Claims 1 to 9,
in which the high-resistance substrate has a resistivity of at least 1000 Ω_{cm}.

## Revendications

1. Structure intégrée de circuit comprenant un composant à micro-ondes actif et au moins un composant passif comme bobine,
- dans laquelle il est prévu un substrat (11) en silicium monocristallin à grande valeur ohmique dans lequel est intégré le composant à micro-ondes,
- dans laquelle le substrat (11) comprend au moins un premier plan (12) de métallisation, un deuxième plan (14) de métallisation et une couche (13) d'isolement interposée entre eux,
- dans laquelle le composant passif comprend au moins une première structure (121) métallique qui est réalisée dans le premier plan (12) de métallisation et une deuxième structure (141) métallique qui est réalisée dans le deuxième plan (14) de métallisation, l'une des structures (121) métalliques étant disposée en tant que structure de circuit coplanaire entre des conducteurs (122) prévus en tant que conducteurs mis à la terre qui sont réalisés dans le même plan (12) de métallisation et ladite une structure (121) métallique étant constituée en piste conductrice disposée sous la forme d'une spirale.

2. Structure de circuit suivant la revendication 1,
- dans laquelle la première structure (121) métallique, constituée en piste conductrice disposée en forme de spirale, est entourée par des conducteurs (122) mis à la terre,
- dans laquelle la deuxième structure (141) métallique s'étend au moins du milieu de la première structure (121) métallique jusqu'au bord de la première structure (121) métallique et
- dans laquelle la deuxième structure (141) métallique est reliée électriquement à la première structure (121) métallique par l'intermédiaire d'un trou (15) de contact qui est empli d'un contact (151) et qui est ménagé dans la couche (13) d'isolement.

3. Structure de circuit suivant la revendication 1, dans laquelle un autre élément passif est constitué en condensateur, la première structure (221) métallique et la deuxième structure (241) métallique formant une première électrode et une deuxième électrode du condensateur et se chevauchant.

4. Structure de circuit suivant la revendication 3,
- dans laquelle la première électrode (221) est constituée en partie d'un conducteur de signal qui s'étend entre des conducteurs (222) mis à la terre,
- dans laquelle la deuxième électrode (241) est reliée électriquement aux conducteurs (222) mis à la terre par l'intermédiaire de deux trous (25) de contact munis de contact (251) et ménagés dans la structure (23) d'isolement sur des côtés opposés du conducteur de signal.

5. Structure de circuit suivant la revendication 3,
- dans laquelle la première électrode (321) est constituée en partie d'un conducteur de signal qui est disposé entre des conducteurs (322) mis à la terre,
- dans laquelle le conducteur de signal est interrompu par une fente,
- dans laquelle la deuxième électrode (341) chevauche la fente et est reliée électriquement au conducteur (323) de signal du côté de la fente qui est éloigné de la première électrode (321) par l'intermédiaire d'un trou (35) de contact muni d'un contact (351) et ménagé dans la couche (33) d'isolement.

6. Structure de circuit suivant la revendication 1,
- dans laquelle il est prévu deux composants passifs parmi lesquels l'un est constitué en bobine et l'autre en condensateur,
- dans laquelle le condensateur comprend deux électrodes (423, 442) parmi lesquelles l'une est réalisée dans ledit un plan (42) de métallisation et l'autre dans l'autre plan (44) de métallisation,
- dans laquelle la bobine comprend dans ledit un plan de métallisation une piste (422) conductrice disposée sous forme de spirale qui est reliée à une pièce (441) de raccordement réalisée dans l'autre plan (44) de métallisation par l'intermédiaire d'un trou de contact muni d'un contact (452) et ménagé dans la couche (43) d'isolement, la pièce (441) s'étendant transversalement à la piste (422) conductrice disposée sous forme de spirale.

7. Structure de circuit suivant la revendication 6,
dans laquelle la bobine, le condensateur et le composant à micro-ondes actif sont reliés en série le long d'un conducteur de signal, la bobine et le condensateur formant un résonateur.

8. Structure de circuit suivant la revendication 7,
- dans laquelle, dans le premier plan (42) de métallisation est prévue une première pièce (421) de conducteur et une deuxième pièce (424) de conducteur qui s'étendent entre des conducteurs mis à la terre dans le premier plan (42) de métallisation,
- dans laquelle la piste (422) conductrice disposée sous forme de spirale de la bobine est disposée dans le premier plan (42) de métallisation entre la première pièce (421) de conducteur et la deuxième pièce (424) de conducteur,
- dans laquelle la pièce (441) de raccordement de la bobine est disposée dans le deuxième plan (42) de métallisation et est reliée électriquement à la première pièce (41) de conducteur au moyen d'un premier contact (451) qui est disposé dans un trou de contact et dans la région du milieu de la bobine à la piste (422) conductrice de la bobine disposée sous forme de spirale par l'intermédiaire d'un deuxième contact (452) qui est disposé dans un trou de contact,
- dans laquelle il est prévu dans le premier plan (42) de métallisation entre la piste (42) conductrice disposée sous forme de spirale et la deuxième pièce (424) de conducteur, une première électrode (423) du condensateur qui est reliée électriquement à la piste (422) conductrice de la bobine disposée sous forme de spirale,
- dans laquelle il est prévu dans le deuxième plan (44) de métallisation une deuxième électrode (442) de condensateur qui chevauche la première électrode (423) de condensateur et qui est reliée à la deuxième pièce (424) de conducteur par un troisième contact (453),
- dans laquelle, une première borne (425) du composant à micro-ondes actif est reliée électriquement à l'une des pièces (421, 424) de conducteur et une deuxième borne du composant (46) à micro-ondes actif est reliée électriquement aux conducteurs (426) mis à la terre.

9. Structure de circuit suivant l'une des revendications 1 à 8, dans laquelle le composant actif est constitué sous la forme d'une diode IMPATT d'un hétérotransistor bipolaire ou d'un transistor MOS à haute fréquence.

10. Structure de circuit suivant l'une des revendication 1 à 9, dans laquelle, le substrat ayant une grande valeur ohmique a une résistance spécifique d'au moins 1 000 Ωcm.
